# EUROPÄISCHE PATENTANMELDUNG

(11) **EP 0 897 216 A2**
(43) Veröffentlichungstag der Anmeldung: **17.02.1999**
(21) Anmeldenummer: 98114232.6
(22) Anmeldetag: 29.07.1998
(51) Int. Cl.: H03H 9/19

(54) **Piezoelektrischer Resonator, Verfahren zur Herstellung des Resonators sowie dessen Einsatz als Sensorelement zum Erfassen der Konzentration eines in einem Fluid enthaltenen Stoffes und/oder der Bestimmung physikalischer Eigenschaften des Fluid**

(30) Priorität: 11.08.1997 DE 19734706
(71) Anmelder: FRAUNHOFER-GESELLSCHAFT ZUR FÖRDERUNG DER ANGEWANDTEN FORSCHUNG E.V., 80636 München (DE)
(72) Erfinder: KÖsslinger, Conrad, Dipl.-Phys., 81247 München (DE); Uttenthaler, Erich, Dipl.-Phys., 80634 München (DE); Nitsch, Andreas, Dipl.-Ing., 88923 Finning (DE); Härle, Thomas, Dipl.-Ing., 86391 Stadtbergen (DE)
(74) Vertreter: Rösler, Uwe

(57) **Zusammenfassung**

Beschrieben wird ein piezoelektrischer Resonator, ein Verfahren zur Herstellung des Resonators sowie dessen Einsatz als Sensorelement, das implementiert in einer Durchflußzelle in eine Meßanlage zum Erfassen der Konzentration eines in einem Fluid enthaltenen Stoffes und/oder der Bestimmung physikalischer Eigenschaften des Fluids integrierbar ist. Der piezoelektrische Resonator ist flächig ausgebildet und weist an seiner Oberfläche elektrische Kontaktbereiche für Elektrode- und Gegenelektrode auf, die mit einer Signalquelle sowie einer Meßeinrichtung verbindbar sind. Zur Messung wird der piezoelektrische Resonator einseitig mit dem zu untersuchenden Fluid in Kontakt gebracht, wobei der Resonator auf eine Massenanlagerung des zu erfassenden Stoffes oder auf eine Änderung der physikalischen Eigenschaften des Fluids durch Änderung seiner Resonanzfrequenz und/oder der Schwingungsamplitude anspricht.

Die Erfindung zeichnet sich dadurch aus, daß der piezoelektrische Resonator Kontaktelektrodenbereiche vorsieht, die von einer einzigen Seite des Resonators kontaktierbar sind. Der Resonator dient als Herzstück eines Sensorelementes das in einer Durchflußzelle integriert ist. Die Durchflußzelle ist modulartig in eine Meßanordnung zum Erfassen der Konzentration eines in einem Fluid enthaltenen Stoffes und/oder der Bestimmung physikalischer Eigenschaften des Fluids einsetzbar.

## Beschreibung

### Technisches Gebiet

Die Erfindung bezieht sich auf einen piezoelektrischen Resonator, ein Verfahren zur Herstellung des Resonators sowie dessen Einsatz als Sensorelement, das implementiert in einer Durchflußzelle in eine Meßanlage zum Erfassen der Konzentration eines in einem Fluid enthaltenen Stoffes und/oder der Bestimmung physikalischer Eigenschaften des Fluids integrierbar ist. Der piezoelektrische Resonator ist flächig ausgebildet und weist an seiner Oberfläche elektrische Kontaktbereiche für Elektrode- und Gegenelektrode auf, die mit einer Signalquelle sowie einer Meßeinrichtung verbindbar sind. Zur Messung wird der piezoelektrische Resonator einseitig mit dem zu untersuchenden Fluid in Kontakt gebracht, wobei der Resonator auf eine Massenanlagerung des zu erfassenden Stoffes oder auf eine Änderung der physikalischen Eigenschaften des Fluids durch Änderung seiner Resonanzfrequenz und/oder der Schwingungsamplitude anspricht.

### Stand der Technik

Piezoelektrische Resonatoren weisen in aller Regel Schwingquarzplättchen auf, die zur Integration und elektrischen Kontaktierung an einen elektrischen Schwingkreis leitende Kontaktbereiche vorsehen, über die das Schwingquarzplättchen mit einer für das Plättchen typischen resonanten Wechselspannung beaufschlagbar ist. Aufgrund der mittlerweile in filigraner Weise herstellbaren Plättchenstruktur kann jedoch das Resonanzverhalten des Resonators u.a. auch durch mechanisches Verspannen des Plättchens, verursacht durch Halteträger oder durch Kontaktieren mit elektrischen Zuleitungen, nachteilhaft beeinträchtigt werden.

Ein Beispiel zum elektrischen Kontaktieren eines Schwingquarzplättchens, das in einem Halteträger fixiert ist, ist in der DE 34 46 612 A1 beschrieben. Das Schwingquarzplättchen 8 weist flächig auf seiner Oberfläche abgeschiedene Elektroden 301 auf und ist zwischen zwei Haltebügeln 201 sowohl räumlich fixiert als auch elektrisch kontaktiert. Nachteilhaft bei dieser bekannten Anordnung ist jedoch, daß das zwischen den Teilen 7 eingeklebte Plättchen 8 bereits durch geringste Kraftmomente, die auf beiden getrennt voneinander angeordneten Teilen 7 einwirken können, mechanisch verspannt werden kann, wodurch das Resonanzverhalten des Plättchens 8 beeinflußt wird.

Piezoelektrische Resonatoren dienen u.a. als aktive Sensorelemente bspw. zum Nachweis eines Stoffes in einem Medium bzw. zum Messen der Konzentration des Stoffes in einer Flüssigkeit. Neben dem vorstehend genannten Problem zur Gewährleistung einer möglichst spannungsfreien Halterung eines Schwingquarzplättchens muß beim Umgang mit Flüssigkeiten zusätzlich der elektrisch zu kontaktierende Schwingquarz flüssigkeitsdicht gegenüber der zu untersuchenden Flüssigkeit isoliert werden, um elektrische Kurzschlüsse zu vermeiden. In der DE 40 13 665 ist ein diesbezüglicher Sensor beschrieben. Der bekannte Sensor sieht ein Schwingquarzplättchen 4 vor, das beidseitig zwischen zwei Silikondichtungen eingeklemmt, und zusätzlich mit leitfähigen Klebstoffkörpern kontaktiert ist. Die Verwendung von leitfähigem Klebstoff hat jedoch zur Folge, daß die elektrische Kontaktierung nicht lösbar ist, wodurch bspw. ein Wechsel des Schwingquarzplättchens nicht möglich oder zumindest mit großem handwerklichen Geschick verbunden ist. Ebenso müssen die Silikondichtungen, die das Schwingquarzplättchen allseitig umfassen hochgenau gearbeitet sein, um mögliche Verformungen im Plättchen zu vermeiden.

Ein ähnlicher Aufbau zum Erfassen bzw. Messen der Konzentration bestimmter Stoffe, die in einer Flüssigkeit gelöst sind unter Verwendung eines Schwingquarzplättchens ist in dem Artikel von W. Stöckl und R. Schumacher, 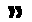 In situ microweighing at the junction metal/electrode", Berichte der Bunsengesellschaft physikalische Chemie 91 (1987), S. 345-349, beschrieben. An den Randbereichen eines Schwingquarzplättchens wird dieses elektrisch beidseitig kontaktiert. Mit einer entsprechenden Flüssigkeitsabdichtung an einer Seite des Schwingquarzplättchens gelangt die zu untersuchende Flüssigkeit in Oberflächenkontakt mit dem Plättchen, so daß sich das Resonanzverhalten des Plättchens entsprechend ändert und die Messung in an sich bekannter Weise durchgeführt werden kann. Ähnlich arbeitende Sensoren unter Verwendung piezoelektrischer Resonatoren zur Immunoanalyse sind aus den Artikeln von K. Davis, T. Leary, 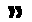 Continuous Liquid-Phase Piezoelectric Biosensor of immunoassays", Anal. Chem. 1989, Nr. 61, p. 1227 bis 1230 sowie von M. Thomson et al.," The potential of the bulk acoustic wave device as a liquid-phase immunosensor", IEEE transactions on ultrasonics, ferroelectrics and fequency control, volume USFC 34, No. 2 March 1987, S. 127-135, bekannt.

Allen bekannten, auf der Basis piezoelektrischer Resonatoren arbeitenden Sensoren zur Messung von Stoffkonzentrationen in Flüssigkeiten sowie auch zur Erfassung von physikalischen Eigenschaften von Flüssigkeiten haften zusammenfassend folgende Nachteile an:

Die Schwingquarzplättchen sind in Halterungen geklebt oder geklemmt, wodurch das Resonanzverhalten des Resonators selbst durch mechanische Verspannungen beeinträchtigt werden kann. Auch sind geklebte und geklemmte elektrische Kontakte auf der Oberfläche des Schwingquarzplättchens insbesondere für den Einsatz zum Messen von Stoffkonzentrationen in Flüssigkeiten nicht uneingeschränkt betriebssicher. Vorkehrungen müssen getroffen werden, um elektrische Kurzschlüsse zu vermeiden. Eine dauerhafte und gleichbleibende Qualität der Kontaktierung läßt sich auf diese Weise nicht erreichen.

In allen bekannten Fällen weist der piezoelektrische Resonator sowohl auf seiner Vorder- als auch auf seiner Rückseite Kontakbereiche auf, die zur elektrischen Kontaktierung an einen elektrischen Schwingkreis bzw. an eine Meßanordnung anzuschließen sind. Die Integration des piezoelektrischen Resonators in eine Gehäusung mit entsprechender elektrischer Kontaktierung ist zeitaufwendig und schwierig. Eine gleichbleibende gute Qualität der elektrischen Eigenschaften insbesondere bei Verwendung eines piezoelektrischen Resonators in einer Halterung, die es gestattet das Schwingquarzplättchen einseitig mit einer zu untersuchenden Flüssigkeit in Kontakt zu bringen, ist nicht möglich.

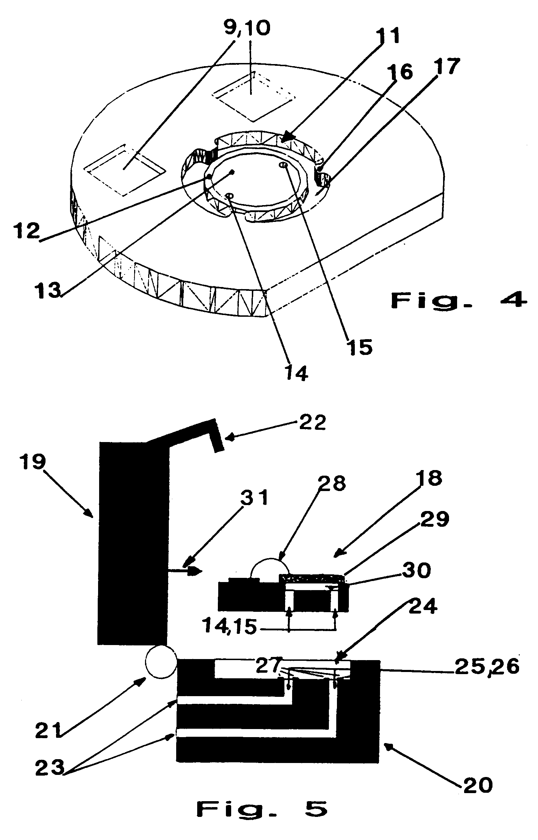

Derartige Halterungen werden auch als Durchflußzellen bezeichnet, die eine Einheit darstellen, in der das Schwingquarzplättchen bereits elektrisch kontaktiert mit Anschlußelektroden verbunden ist. Ferner ist ein definierter Zu- und Abflußkanal vorgesehen, über die die zu untersuchende Flüssigkeit dem piezoelektrischen Resonator gezielt zu- und wieder abführbar ist. Eine derartige Durchflußzelle geht beispielsweise aus dem obenstehend genannten Artikel von M. Thomson in Fig. 4 hervor.

Für Anwender derartiger Durchflußzellen sind ein hoher Zeitaufwand und handwerkliches Geschick beim Wechseln der Zelle notwendig. Insbesondere im Bereich der Biosensorik sind häufige Wechselmaßnahmen notwendig, zumal für jeden unterschiedlich zu erfassenden Stoff eine eigens präparierte Durchflußzelle notwendig ist. Die mit dem Wechsel verbundenen Arbeiten stehen einer kommerziellen Verbreitung von piezoelektrischen Resonatoren entgegen.

### Darstellung der Erfindung

Der Erfindung liegt die Aufgabe zugrunde, einen piezoelektrischen Resonator gemäß dem Oberbegriff des Anspruchs 1 derart weiterzubilden, daß er zuverlässig und ohne Gefahr von Kurzschlüssen elektrisch kontaktiert werden kann und eine Integration in Trägervorrichtungen frei von mechanischen Verspannungen erfolgen soll. Überdies soll der piezoelektrische Resonator in ein erfindungsgemäßes Sensorelement integrierbar sein, das zum Erfassen der Konzentration eines in einem Fluid enthaltenen Stoffes oder zur Bestimmung physikalischer Eigenschaften eines Fluids ausgelegt ist und keine aufwendigen Dichtungsmaßnahmen erfordert, um einen sicheren Betrieb insbesondere gegenüber elektrischem Kurzschluß, zu gewährleisten. Das Sensorelement soll leicht herstellbar und insbesondere derart konzipiert sein, so daß auf umständliche Dichtungsmaßnahmen verzichtet werden kann. Das Sensorelement soll insbesondere auch Bestandteil einer Durchflußzelle sein, die ein leichtes Auswechseln innerhalb einer Meßanordnung gestattet. Insbesondere soll die Durchflußzelle ohne großen konstruktiven und handhabungstechnischen Aufwand elektrisch kontaktierbar und an ein etwaiges Flüssigkeitskanalsystem fluiddicht anschließbar sein.

Der Erfindung liegt die Idee zugrunde, einen piezoelektrischen Resonator, der flächig ausgebildet ist, mit einem auf der Oberfläche des piezoelektrischen Resonators aufgebrachten Elektroden- und mindestens einem Gegenelektrodenbereich derart auszugestalten, daß eine erste Seite des piezoelektrischen Resonators ausschließlich einen Elektrodenbereich vorsieht, der elektrisch leitend mit einem Elektrodenbereich auf der zweiten Seite des piezoelektrischen Resonators verbunden ist, auf der gegenüber dem Elektrodenbereich elektrisch isoliert der Gegenelektrodenbereich vorgesehen ist.

Der als Schwingquarzplättchen ausgebildete piezoelektrische Resonator weist eine erfindungsgemäße Elektroden- bzw. Gegenelektrodenanordnung auf, die es erlaubt den piezoelektrischen Resonator von nur einer einzigen Seite aus zu kontaktieren. Hierbei ist der Elektrodenbereich, der ausschließlich auf einer Seite vorgesehen ist, über den Rand des Schwingquarzplättchen auf die gegenüberliegende Seite nach oben geführt, so daß eine elektrische Kontaktierung des Elektrodenbereiches von der gegenüberliegenden Seite erfolgen kann. Zudem sieht die gegenüberliegende Seite des Schwingquarzplättchens wenigstens einen Kontaktbereich für die Gegenelektrode auf, der elektrisch isoliert gegenüber dem Elektrodenbereich angeordnet ist.

Alternativ oder zusätzlich zu der elektrischen Kontaktierung des Elektrodenbereiches auf die gegenüberliegende Schwingquarzplättchenseite über den Rand des Plättchens, können auch elektrische Leitpfade die senkrecht durch das Plättchen verlaufen, einen elektrischen Kontakt zwischen den Elektrodenbereichen auf beiden Oberflächen des Plättchens herstellen.

Vorteilhaft ist eine mittige Anordnung eines Gegenelektrodenbereiches auf der gegenüberliegenden Seite des piezoelektrischen Resonators, da auf diese Weise eine sichere räumliche Beabstandung zwischen dem auf der gleichen Seite befindlichen Elektrodenbereich zum Gegenelektrodenbereich realisierbar ist.

Alternativ oder zusätzlich sind die Zwischenräume zwischen beiden elektrisch leitenden Bereichen mit elektrisch isolierendem Material aufgefüllt. Auch sind je nach Bedarf zwei oder mehr Gegenelektrodenbereiche auf der Resonatoroberfläche aufbringbar.

Als Material für den piezoelektrischen Resonator eignet sich ein Scherschwinger aus α-Quarz, der gemäß dem AT-Schnitt bearbeitet worden ist.

Um eine ausreichende Haftfähigkeit zwischen dem Schwingquarzplättchen und den auf diesem aufzubringenden Elektroden- bzw. Gegenelektrodenschichten zu erreichen, ist zusätzliche eine Haftschicht direkt auf der Oberfläche des Schwingquarzplättchens aufgebracht, die vorzugsweise aus NiCr, Cr, Ni, Ti und/oder W besteht. Als Material für die Elektroden bzw. Gegenelektrodenbereiche eignet sich vorzugsweise Gold. Typische Schichtdicken für die Haftschicht bewegen sich etwa zwischen 10 und 50 nm, wohingegen die Schichtdicke der aus dem elektrisch leitenden Material bestehenden Elekroden- bzw. Gegenelektrodenschichten etwa zwischen 50 bis 500 nm betragen.

Zur elektrischen Kontaktierung des piezoelektrischen Resonators weisen die auf dem Schwingquatzplättchen aufgebrachten Elektroden- und/oder Gegenelektroden stegartig ausgebildete Absätze auf, die zum Anbringen von Anschluß bzw. Bonddrähten vorgesehen sind. Durch das Vorsehen konkreter Kontaktstrukturen in den Elektroden- und Gegenelektrodenbereichen können bauelementspezifische Abweichungen, die sich möglicherweise auf etwaige Meßergebnisse auswirken können, erheblich eingeschränkt werden.

Der erfindungsgemäße piezoelektrische Resonator ist wie vorstehend beschrieben mit einem Elektrodenbereich überzogen, der sich von einer Seite auf die andere Seite entweder über den Rand des Resonators oder über elektrische Verbindungskanäle auf die andere Seite des Resonators erstreckt. Zur wirtschaftlichen Herstellung derartiger piezoelektrischer Resonatoren, die aus flächigen Substratplättchen bestehen und vorzugsweise Schwingquarzplättchen sind, wird erfindungsgemäß ein Verfahren zur Herstellung einer Beschichtung aus derartigen Substratplättchen angegeben, das sich aus folgenden Verfahrensschritten zusammensetzt:

Geeignet ausgewählte Substratplättchen, die in beliebiger Dicke und Größe käuflich zu erwerben sind, werden auf einen Träger plaziert, der jedes Plättchen an wenigstens einer Fixierstelle derart fixiert, daß das Plättchen für den Beschichtungsvorgang ansonsten frei zugänglich ist. Auf die, auf dem Träger aufgebrachten Substratplättchen wird eine Abschattungsmaske aufgebracht, wobei die Abschattungsmaske derart strukturiert ist, daß ein Bereich auf der Plättchenoberfläche, der nicht beschichtet werden soll, von einer Maskenstruktur abgedeckt wird. Zum Fixieren wird schließlich ein Fixierdeckel auf die Abschattungsmaske lösbar fest aufgebracht, der identisch zum Träger strukturiert ist. Diese, die zu beschichtenden Substratplättchen tragende Anordnung wird einem an sich bekannten Beschichtungsprozeß zugeführt, in dem, ohne den Prozeß zu unterbrechen, sowohl die Oberseite als auch die Unterseite der Substratplättchen beschichtet wird. Insbesondere gewährt die erfindungsgemäße Trägerstruktur eine Beschichtung des Plättchens über den Randbereich von einer Seite zur anderen Seite, so daß auf das Plättchen, das Plättchen umschließende Ablagerungen abgeschieden werden können.

In üblicher Weise erfolgt der Beschichtungsvorgang mittels CVD oder Sputter-Verfahren. Aus Gründen der besseren Haftungsfähigkeit der elektrisch leitenden Elektroden- und Gegenelektrodenbereichen auf dem Plättchen, werden die Substratplättchen zunächst mit einer Haftschicht beaufschlagt, die vorzugsweise aus Nickelchrom, Nickel, Titan und/oder Wolfram bestehen. Nach dem Abscheiden einer typischerweise 10 bis 50 nm dicken Haftschicht wird anschließend auf die Haftschicht eine elektrisch leitfähige Schicht abgeschieden, die für viele Anwendungsfälle des piezoelektrischen Resonators aus Gold besteht und eine Schichtdicke von etwa 50 - 500 nm aufweist. Je nach weiterer Verwendung werden auf den Substratplättchen Passivierungsschichten abgeschieden, die aus folgenden Elementverbindungen bestehen: SiC, Fi₃N₄, SiO₂.

Je nach Oberflächenqualität der käuflich zu erwerbenden Substratplättchen ist vor dem Beschichtungsvorgang ein Reinigungsschritt der in der Trägerstruktur eingebrachten Substratplättchen vorzusehen, der im Rahmen eines an sich bekannten Ätzvorganges durchgeführt werden kann. Selbstverständlich sind die Materialien des Trägers, der Abschattungsmaske sowie des Fixierdeckels derart zu wählen, daß sie inert gegenüber den durchzuführenden Ätz- bzw. Beschichtungsvorgängen sind. Ein geeignetes Material hierfür stellt Aluminium dar.

Der erfindungsgemäße piezoelektrische Resonator kann grundsätzlich vielseitige Verwendung finden, wie beispielsweise in Telekommunikationsgeräten, in denen eine sehr stabile Resonanzfrequenz benötigt wird, doch richten sich die folgenden Ausführungen auf den Einsatz des piezoelektrischen Resonators als Sensorelement, mit dem der Nachweis und die Erfassung der Konzentration von in Fluiden gelösten Stoffen sowie zur Messung physikalischer Eigenschaften von Fluiden möglich ist.

Durch die erfindungsgemäße Elektrodenanordnung auf dem piezoelektrischen Resonator ist ein Sensorelement zum Erfassen der Konzentration eines in einem Fluid enthaltenen Stoffes oder zur Bestimmung physikalischer Eigenschaften eines Fluids derart erfindungsgemäß ausgestaltet, daß das Sensorelement nur von einer einzigen Seite elektrisch kontaktierbar ist und auf diese Weise mit einer für den Betrieb des Sensorelementes erforderlichen Signalquelle und einer Meßanordnung verbindbar ist.

Durch die elektrische Kontaktierung des Sensorelementes von nur einer Seite ist es möglich, das zu untersuchende Fluid ausschließlich mit der Seite des piezoelektrischen Resonators in Kontakt zu bringen, auf der ausschließlich der Elektrodenbereich aufgebracht ist. Das Sensorelement erlaubt es durch die Änderung seines Resonanzverhaltens bei Inkontakttreten mit dem zu untersuchenden Fluid die physikalischen Eigenschaften des Fluids hinsichtlich Viskosität, Elastizität sowie Dichte des Fluids zu erfassen. Bringt man zusätzlich auf der Elektrodenbereichsseite eine chemische bzw. biochemische Schicht auf, an der sich gezielt Stoffe ab- bzw. anlagern, die in einem zu untersuchenden Fluid enthalten sind, so erfolgt an dieser Seite eine Massenanlagerung durch die das Resonanzverhalten des piezoelektrischen Resonators ebenfalls beeinflußt wird.

Zur operativen Durchführung der vorstehend genannten Messungen wird das erfindungsgemäße Sensorelement in eine erfindungsgemäß ausgebildete Durchflußzelle integriert, die vorzugsweise als scheibenartiges Spritzgußteil ausgebildet ist und erfindungsgemäß an ihrer Oberfläche zwei elektrische Kontaktbereiche aufweist, die über Anschluß- bzw. Bonddrähte mit den Kontaktbereichen für die Elektrode und Gegenelektrode des Sensorelementes verbindbar sind. Zur Integration des Sensorelementes in das Spritzgußteil, weist dieses an seiner Oberfläche eine Vertiefung auf, in die das Sensorelement einsetzbar ist. Hierbei schließt das Sensorelement mit seiner ausschließlich den Elektrodenbereich aufweisenden Seite und das Spritzgußteil einen Hohlraum ein, der das Durchflußzellenvolumen bildet, wobei der Hohlraum wenigstens zwei Durchlaßkanäle aufweist, durch die das zu untersuchende Fluid zu- bzw. ableitbar ist.

Der besondere Vorteil der erfindungsgemäß ausgestalteten Durchflußzelle besteht darin, daß die Durchflußzelle als leicht auswechselbares Modul in eine für die Messung der Konzentration eines Stoffes in einer Flüssigkeit bzw. der Ermittlung der physikalischen Eigenschaften eines Fluids ausgelegten Meßanordnung leicht implementierbar und aus dieser wieder entnehmbar ist. Insbesondere gewährt die Durchflußzelle durch die bloße Kontaktierung des Sensorelementes mittels Bonddrähten einen spannungsfreien Sitz, der nicht durch Zugspannungen, die beispielsweise über Anschlußdrähte auf das Sensorelement einwirken können, irritiert wird.

Die eigentliche elektrische Kontaktierung der Durchflußzelle erfolgt über Kontaktbereiche, die auf dem Spritzgußteil aufgebracht sind und auf die geeignet ausgestaltete Anschlußkontakte aufsetzbar sind.

Die erfindungsgemäße Durchflußzelle eignet sich als modulare Einheit für einen unkomplizierten und schnellen Einsatz in eine Meßanordnung, die zum Erfassen der Konzentration eines in einem Fluid enthaltenen Stoffes und/oder der Bestimmung physikalischer Eigenschaften des Fluids ausgelegt ist. Da in allen bekannten Anordnungen das Einsetzen des Sensorelementes respektive der, das Sensorelement einschließenden Durchflußzelle mit großem handwerklichen Aufwand verbunden ist, zumal häufig feste Klebeverbindungen und umständliche Dichtungsmaßnahmen verwendet werden, ist eine gattungsgemäße Anordnung, wie sie bspw. aus der DE 40 13 665 C2 hervorgeht, erfindungsgemäß dadurch ausgebildet, daß ein Fluidkanalsystem fluiddicht auf der einen Seite der Durchflußzelle ankoppelbar ist und Anschlußelektroden für eine Signalquelle und eine Meßanordnung mit den elektrischen Kontaktbereichen an der gegenüberliegenden Oberfläche der Durchflußzelle verbindbar sind.

Die Anordnung weist eine Art Schnellwechselgehäuse auf, die aus zwei gegeneinander festlegbaren Gehäuseteilen zusammengesetzt ist, zwischen denen die Durchflußzelle lediglich in eine entsprechende Vertiefung, die an die Außenkontur der Durchflußzelle angepaßt ist, eingelegt werden kann. Weitere Einzelheiten zu der erfindungsgemäßen Anordnung werden in Verbindung mit den Figuren beschrieben.

Die aus den vorstehend beschriebenen erfindungsgemäßen Einzelkomponenten zusammengesetzte Meßanordnung eignet sich zur Durchführung verschiedenartiger Messungen. So ist es unter Verwendung geeigneter biochemischer Reaktionsschichten, die einseitig auf den piezoelektrischen Resonator aufbringbar sind, es möglich, die Konzentration bestimmter biochemischer Stoffe bzw. Mikroorganismen zu bestimmen. Die Anordnung kann quasi als Immunosensor aufgefaßt werden. Ebenso kann die Reaktionskinetik zwischen mindestens zwei Substanzen bestimmt werden, wobei eine Substanz an der Resonatoroberfläche in immobilisierter Form abgeschieden wird. Auch ohne zusätzlichem Aufbringen einer biochemisch wirksamen Schicht auf der Oberfläche des piezoelektrischen Resonators dient die erfindungsgemäße Anordnung zur Messung allgemein physikalischer Eigenschaften von Fluiden. Insbesondere kann die Anordnung auch als Waschmittelsensor oder Prozeßrheometer verwendet werden.

### Kurze Beschreibung der Zeichnungen

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1: Querschnitt und Draufsichtdarstellung eines erfindungsgemäß ausgebildeten piezoelektrischen Resonators,
- Fig. 2: Erforderliche Trägerstrukturen zur Durchführung des Verfahrens zur Herstellung des in Fig. 1 hergestellten piezoelektrischen Resonators,
- Fig. 3: Querschnittsdarstellung eines Ausschnittes durch die Trägerstruktur zum Aufbringen von Elektrodenmaterial auf einen piezoelektrischen Resonator,
- Fig. 4: perspektivische Darstellung der Grundstruktur einer Durchflußzelle,
- Fig. 5: schematisierte Querschnittsdarstellung durch ein erfindungsgemäß ausgestaltetes Schnellwechselgehäuse sowie
- Fig. 6: Explosionsdarstellung einer Ausführungsform eines Schnellwechselgehäuses.

### Beschreibung von Ausführungsbeispielen sowie der gewerblichen Anwendbarkeit

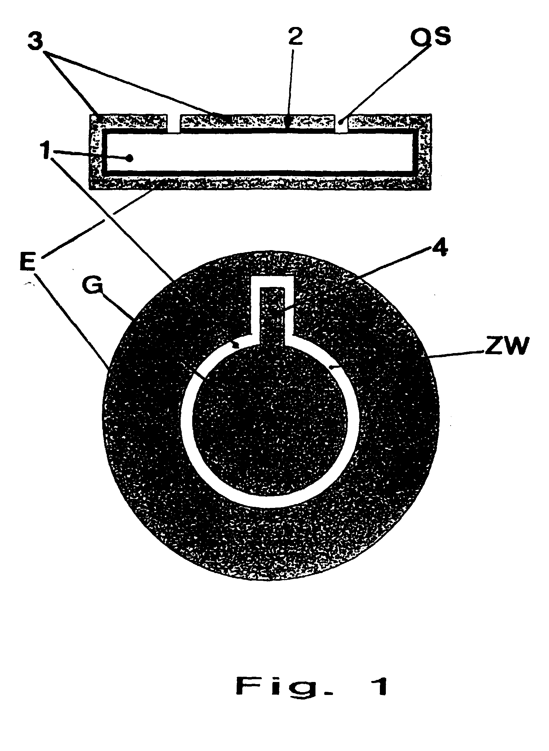

In Fig. 1 ist im oberen Teil eine Querschnittsdarstellung durch einen beschichteten piezoelektrischen Resonator dargestellt, dessen Kern aus einem Quarzsubstrat 1 besteht. Das als Schwingquarzplättchen ausgebildete Quarzsubstrat 1 ist gemäß Fig. 1 obere Darstellung mit einer Haftschicht 2 weitgehend vollständig mit Ausnahme der beiden offen gelassenen Stellen OS überzogen. Die Haftschicht 2 besteht aus einer Titan-Wolfram-Legierung und ist ferner mit einer elektrisch leitenden Schicht 3 überzogen, die vorzugsweise aus Gold besteht.

Im gezeigten Ausführungsbeispiel gemäß Fig. 1 ist die gesamte Unterseite des piezoelektrischen Resonators mit einer Goldschicht überzogen, die zugleich auch den Elektrodenbereich E definiert. Der Elektrodenbereich E zieht sich über die Ränder des piezoelektrischen Resonators auf die Oberseite des Quarzsubstrats 1 auf der zusätzlich ein Gegenelektrodenbereich G abgeschieden ist, der gegenüber dem Elektrodenbereich E räumlich beabstandet und somit elektrisch isoliert angeordnet ist. Eine vorteilhafte flächige Anordnung von Elektrodenbereich E und Gegenelektrodenbereich G auf der Oberseite des piezoelektrischen Resonators ist aus der unteren Darstellung gemäß Fig. 1 zu entnehmen. Zusätzlich weist der mittige Gegenelektrodenbereich G einen stegartigen Absatz 4 auf, durch den ein Bereich zur elektrischen Kontaktierung mittels Bonddrähte vorgegeben ist. Neben der bloßen räumlichen Beabstandung zwischen Elektrodenbereich E und Gegenelektrodenbereich G kann der Zwischenraum ZW mit elektrisch isolierendem Material aufgefüllt werden, um Kurzschlußeffekte, die beispielsweise durch Feuchtigkeit auftreten können, vollständig auszuschließen.

Die Herstellung des in Fig. 1 gezeigten piezoelektrischen Resonators ist unter Zuhilfenahme der in Fig. 2 dargestellten Trägerstrukturen möglich. Zwar ist in Fig. 1 ein rundes Schwingquarzplättchen dargestellt, doch sind auch davon abweichende Geometrien, beispielsweise rechteckige Formen, denkbar.

Zur Beschichtung werden die unbehandelten Schwingquarzplättchen, die gegebenenfalls zur Reinigung einem Ätzschritt unterzogen werden, auf einen Träger 5 aufgebracht, der in der Draufsichtdarstellung links in Fig. 2 abgebildet ist. Der Träger 5 weist eine Vielzahl von Öffnungen auf, über die jeweils die zu beschichtenden Quarzplättchen aufgelegt werden. Die Öffnungen sind derart geformt, daß die Plättchen jeweils nur mit ihrem peripheren Randbereich mit minimaler Auflagefläche auf dem Träger 5 aufliegen. Somit ist gewährleistet, daß das Plättchen weitgehend frei zugänglich ist für die im Beschichtungsprozeß sich am Plättchen abscheidenden Materialien.

Über die auf dem Träger 5 aufliegenden Schwingquarzplättchen wird eine Abschattungsmaske 6 aufgelegt, die pro zu beschichtendem Schwingquarzplättchen einen Ringbereich 7 vorsieht, der unmittelbar auf dem Plättchen aufliegt, so daß eben dieser Bereich während eines Beschichtungsprozesses nicht beschichtet wird. Zum Fixieren der Abschattungsmaske 6 dient ein Fixierdeckel 8, der gleichermaßen wie der Träger 5 strukturiert ist.

Die zwischen der Trägerstruktur eingebrachten, zu beschichtenden Quarzsubstrate können ohne Öffnen der Halterung auf beiden Seiten mit dem entsprechenden Schichtmaterial beschichtet werden, ohne daß der Beschichtungsvorgang unterbrochen werden muß. So kann in einem ersten Durchgang zunächst eine Haftschicht auf die einzelnen Substratoberflächen aufgebracht werden, die typischerweise eine Schichtdicke von etwa 35 nm betragen. Als besonders geeignete Materialien eignen sich hierzu Titan-Wolframlegierungen. Zum Abscheiden der elektrisch leitfähigen Materialschicht eignen sich grundsätzlich jegliche bondbare Metallisierungsschichten, doch wird wie vorstehend bereits erwähnt, in den häufigsten Fällen Gold verwendet.

In der gleichen Halterung können auch Passivierungsschichten auf die Substratoberflächen aufgebracht werden, wie beispielsweise SiC, Si₃N₄, SiO₂ oder Plasmapolymerschichten.

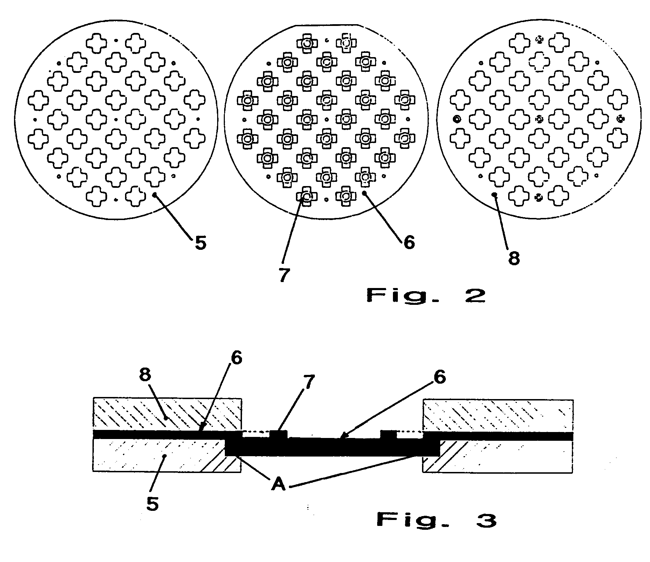

Vorzugsweise bestehen die in Fig. 2 dargestellten Masken aus Aluminium und weisen einen Maskendurchmesser typischerweise von 125 mm auf. Eine Querschnittsdarstellung von einem zu beschichtenden Schwingquarzplättchen, das zwischen dem Träger 5 und dem Fixierdeckel 7 eingebracht ist, ist in Fig. 3 dargestellt. Das Schwingquarzplättchen 1 ragt lediglich an den Haltestellen zur Unterstützung in etwa 100 µm tiefe Absätze A ein, die in den Träger 5 eingearbeitet sind. Unmittelbar über den zu beschichtenden Schwingquarzplättchen 1 und dem Träger 5 ist die Abschattungsmaske 6 angeordnet, über die der Fixierdeckel 7 aufgebracht ist.

Der Fixierdeckel 7 weist Verbindungsstifte zum Träger 5 auf, über die der Fixierdeckel mit dem Träger 5 fixiert werden kann. Durch die im gezeigten Beispiel kreuzförmige Struktur der Durchbrüche im Träger 5 sowie Fixierdeckel 8 kann das Beschichtungsmaterial auch an die Ränder der Schwingquarzplättchen gelangen, so daß der Elektrodenbereich von einer Seite auf die andere Seite elektrisch kontaktiert werden kann.

In Fig. 4 ist ein erfindungsgemäß ausgestaltetes Spritzgußteil zur Realisierung einer Durchflußzelle dargestellt, das sowohl aus herstellungstechnischen Gründen sowie aus Gründen der chemischen Beständigkeit aus Kunststoff vorzugsweise aus Polyaryletherketon hergestellt ist. Insbesondere bietet der Kunststoff PEEK einerseits bei dünnen Schichten akzeptable Wärmeübergänge und zum anderen ist er chemisch beständig, warmfest bis 300 °C und gut zu bearbeiten.

Der mittels Spritzgußverfahren herstellbare Formkörper gemäß Fig. 4 sieht auf seiner Oberfläche zwei Vertiefungen 9, 10 vor, in die zur elektrischen Kontaktierung Kontaktflächen, vorzugsweise goldbesputterte Siliziumplättchen (nicht in der Figur dargestellt) eingeklebt werden können.

Mittig in dem Formkörper ist eine Vertiefung 11 eingearbeitet, die für das Einlegen des vorstehend beschriebenen Sensorelementes geeignet ist. In der Vertiefung 11 ist eine Struktur eingearbeitet, die einen umlaufenden Auflagesteg 12 vorsieht, der ringförmig über eine innere Fläche 13, die der Auflagesteg 12 umschließt, emporragt. Im Bereich der inneren Fläche 13 sind zwei Durchgangskanäle 14 und 15 eingearbeitet, durch die das zu untersuchende Fluid zu- bzw. ableitbar ist. Bündig auf den Auflagesteg 12 ist ein nicht in der Fig. 4 dargestelltes Schwingquarzplättchen aufgelegt, das seitlich durch drei Führungsbegrenzungen 16 mittig in der Vertiefung 11 auf dem Auflagesteg 12 zentriert wird. Das auf dem Auflagesteg 12 aufliegende Sensorelement wird mit geeignetem Klebstoff fest fixiert, wobei überschüssiger Klebstoff in die peripher um den Auflagesteg 12 umlaufende Nut 17 abfließen kann. Das Sensorelement schließt in dieser Anordnung einen sich, zwischen der Unterseite des Schwingquarzplättchens und der inneren Fläche 13 bildenden Hohlraum ein, der die Durchflußzellenkammer bildet. Auf der gegenüberliegenden Oberseite des Sensorelementes werden die Elektroden und Gegenelektrodenbereiche mittels Bonddrähten mit den elektrischen Kontaktflächen 9 und 10 verbunden. Durch die relativ großflächig ausgestalteten Kontaktflächen 9 und 10 bieten diese relativ robuste elektrische Anschlußmöglichkeiten, die als auf die Kontaktbereiche aufsetzbare Anschlußelektroden ausgebildet sind.

Unabhängig vom mechanischen Anpreßdruck etwaiger Anschlußelektroden auf den elektrischen Kontaktbereichen 9 und 10 verbleibt die elektrische Kontaktierung des eingeklebten Sensorelementes frei von äußeren mechanischen Spannungen, da das Sensorelement ausschließlich mittels feinster Bonddrähte kontaktiert ist.

Die in Fig. 4 dargestellte Durchflußzelle ist als modulares Einbauelement zu betrachten und ist je nach gewünschten Meßaufgaben speziell zu modifizieren. Die Durchflußzelle gestattet einen schnellen Ein- bzw. Ausbau aus einer Meßanordnung, die im folgenden beschrieben wird und kann darüber hinaus als Verbrauchsmaterial bzw. als Einwegartikel verstanden werden.

In Fig. 5 ist eine bevorzugte Ausführungsform einer Meßanordnung zum Messen der Konzentration eines in einem Fluid enthaltenen Stoffes und/oder der Bestimmung physikalischer Eigenschaften des Fluids dargestellt. Die Anordnung besteht aus zwei Gehäuseteilen 19, 20, die über ein Scharniergelenk 21 gegeneinander schwenkbar verbunden sind. Das obere Gehäuseteil 19 sieht darüber hinaus eine Schließvorrichtung in Form eines Schließhakens 22 vor, durch den das obere Gehäuseteil 19 mit dem unteren Gehäuseteil 20 fest gegeneinander gelagert werden kann. Das untere Gehäuseteil 20 ist mit einem Fluidkanalsystem 23 ausgestattet, durch dessen einen Kanal das zu untersuchende Fluid dem Gehäuseteil 20 zugeführt und über den anderen Kanal das Fluid aus dem Gehäuseteil abgeführt werden kann. Ferner sieht das untere Gehäuseteil eine Ausnehmung 24 vor, die paßgenau an die äußere Kontur der mit der Bezugsziffer 18 gekennzeichneten Durchflußzelle ausgeformt ist. Bündig mit den in der Durchflußzelle 18 eingearbeiteten Durchgangskanäle 14, 15 sind die Öffnungen 25, 26 des Fluidkanalsystems 23 in dem unteren Gehäuseteil 20 eingearbeitet. Zur fluiddichten Verbindung zwischen dem unteren Gehäuseteil 20 und der Durchflußzelle 18 sind jeweils Dichtungsringe 27 vorgesehen.

Die Durchflußzelle 18 besteht wie im vorgeschilderten Fall unter Bezugnahme auf Fig. 4 aus einem Spritzgußteil in das jeweils zwei elektrische Kontaktbereiche 9, 10 eingearbeitet sind, die über Bonddrähte 28 mit den Elektroden bzw. Gegenelektrodenbereichen auf dem Sensorelement 29 elektrisch verbunden sind. Das Sensorelement 29 schließt mit der Durchflußzelle ein Durchflußzellenvolumen 30 ein, in dem das zu untersuchende Fluid mit der Unterseite des Sensorelementes 29 in Kontakt tritt, wodurch das Resonanzverhalten des Sensorelementes beeinflußt wird.

Die in die Ausnehmung 24 eingelegte Durchflußzelle 18 wird mittels als Federkontakte ausgebildete Anschlußelektroden 31, die mit dem oberen Gehäuseteil 19 verbunden sind, kontaktiert. Durch entsprechendes Verriegeln beider Gehäuseteile 19 und 20 gegeneinander mittels des Schließhakens 22 wird zum einen die Durchflußzelle fluiddicht von oben gegen die Dichtungen 27 gepreßt und zugleich mit Hilfe der Federkontakte 31 elektrisch kontaktiert.

Die Meßanordnung gewinnt insbesondere dadurch an Attraktivität, da durch einfaches Verschwenken und Verriegeln beider Gehäuseteile gegeneinander die Durchflußzelle betriebssicher in der Anordnung integriert werden kann. Nach Vollendung einer Messung ist die Durchflußzelle durch Entnehmen aus der Meßanordnung einfach und kostengünstig durch das Implementieren einer neuen, unverbrauchten Durchflußzelle zu ersetzen. Die Meßanordnung ist quasi als Schnellwechselmeßgehäuse ausgebildet, das es erlaubt eine Vielzahl unterschiedlich präparierter Durchflußzellen in unmittelbarer Meßabfolge ohne großen Aufwand beim Wechsel gegeneinander auszutauschen.

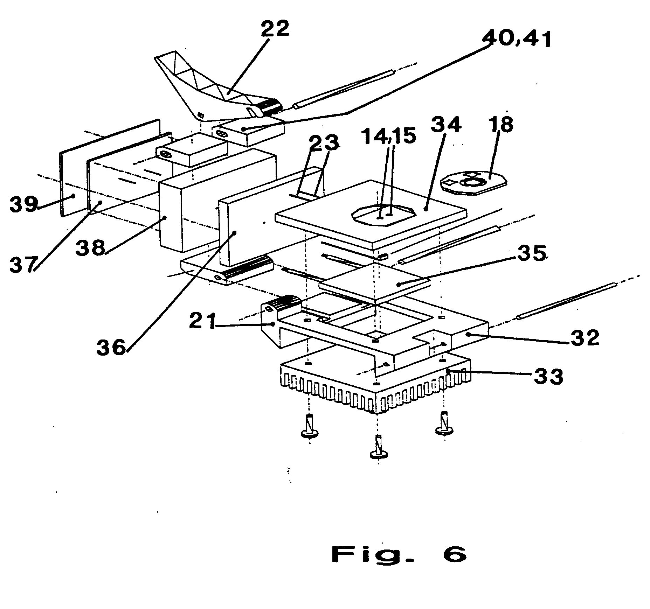

Aus Fig. 6 ist eine detailliertere Darstellung des vorstehend beschriebenen Schnellwechselgehäuses im Rahmen einer Explosionsdarstellung gezeigt. Das untere Gehäuseteil 19, ist aus einer Vielzahl einzelner Komponenten zusammengesetzt: Eine Trägerplatte 32, an der das Scharniergelenk 21 angelenkt ist, dient zur Aufnahme eines Kühlkörpers 33 sowie einer Grundplatte 34. Außerdem besitzt die Trägerplatte 32 Ausfräsungen für die Aufnahme einer Heiz/Kühleinrichtung 35, die vorzugsweise als Peltierelement ausgebildet ist. Der Kühlkörper 23 sowie die Grundplatte 34 sind mit der dazwischen liegenden Heiz/Kühleinrichtung 35 durch die Trägerplatte 32 fest miteinander verschraubt. Die Grundplatte 34 besitzt an ihrer Oberseite eine Ausnehmung für die Aufnahme der Durchflußzelle 18 sowie eine Vertiefung zur erleichterten Entnahme der Durchflußzelle 18 aus der Grundplatte 34. Die Zu- und Ableitungen des Fluidkanalsystems 23 sind hinter der Grundplatte 34 angebracht und münden in den Durchgangskanälen 14 und 15, die symmetrisch in der Durchflußzelle eingebracht sind.

Das obere Gehäuseteil 19 besteht aus einer Druckplatte 36, einem Oszillator 37 der als Signalquelle zum Betrieb des piezoelektrischen Resonators dient mit zugehörigem Gehäuse 38, einem Deckel 39, dem Schließhaken 22 sowie zugehörigen Halteelementen 40 und 41.

Das Oszillatorgehäuse 38 dient überdies als Aufnahme für die Druckplatte 36, die von unten an das Oszillatorgehäuse angebracht ist, sowie zum Anbringen der Halterungen 40 und 41.

Zum Einlegen der Durchflußzelle 18 wird die Meßanordnung über den Schließhaken 22 entriegelt und das obere Gehäuseteil 19 bis zum Anschlag geöffnet. Anschließend wird die entsprechend präparierte Durchflußzelle vorzugsweise mit Hilfe einer Pinzette in die vorgesehene Ausnehmung in der Grundplatte eingelegt. Beim Schließen der Vorrichtung wird die Durchflußzelle über zwei Federkontakte, die vom Oszillator 37 durch das Gehäuse 38 und die Grundplatte 37 durchgeführt sind, kontaktiert. Die fluidische Abdichtung der Durchflußzelle 18 gegen die Grundplatte 35 erfolgt durch den entstehenden Druck auf die Dichtringe 27 (s. hierzu Fig. 5 in der Grundplatte). Zum Verschließen der Meßanordnung wird der Schließhaken 22 soweit nach unten gedruckt, bis er in eine entsprechende Rasterung einrastet.

Vorteil dieses Aufbaus ist die schnelle Austauschbarkeit und die einfache Handhabung der Durchflußzelle. Die Einströmöffnung in der Grundplatte ist soweit von der eigentlichen Meßzelle entfernt, daß eine Drift der Oszillatorfrequenz durch thermische Spannungen minimiert werden kann. Außerdem ist durch die Gestaltung der Meßanordnung gewährleistet, daß das zu untersuchende Fluid einen ausreichend langen Weg durch die durch die Heiz- und Kühleinrichtung temperierte Grundplatte durchläuft, um einen nötigen Temperaturausgleich für stabile Messungen zu erfahren.

Je nach Präparation des in die Durchflußzelle eingesetzten Sensorelementes können unterschiedliche Meßaufgaben erfüllt werden. Wird das Sensorelement einseitig mit einem biochemischen Stoff, vorzugsweise einem Antigen beschichtet, so lagern sich selektiv Mikroorganismen oder ähnliche Bestandteile aus dem zu untersuchenden Fluid an der Sensoroberfläche ab. Die dadurch entstehende Massenänderung an den Resonatoroberfläche führt zu einer Resonanzänderung, die sich in der Änderung der Resonanzfrequenz und/oder Schwingungsamplitude auswirkt. Mit Hilfe einer geeigneten Meßanordnung können diese Resonanzänderungen exakt festgestellt werden und in Verhältnis zu der Konzentration des angelagerten Stoffes in der zu untersuchenden Flüssigkeit bzw. dem Fluid gesetzt werden. Ein bevorzugtes Anwendungsgebiet der vorbeschriebenen Meßanordnung dient dem Erfassen von Legionellen in Wasser.

Auch ohne einer extra vorgesehenen Beschichtung des Sensorelementes mit einer chemischen bzw. biochemischen Schicht dient die Meßanordnung zur Bestimmung der physikalischen Eigenschaften von Fluiden, wie beispielsweise die Erfassung der Dichte, Viskosität und/oder Elastizität von Fluiden. Auf diese Weise sind bspw. Waschmittelsensoren oder Prozeßrheometer realisierbar.

### BEZUGSZEICHENLISTE

- 1: Quarzsubstrat
- 2: Haftschicht
- 3: elektrisch leitende Schicht
- 4: stegartiger Absatz
- 5: Träger
- 6: Abschattungsmaske
- 7: Ringbereich
- 8: Fixierdeckel
- 9: Vertiefung für elektrische Kontaktflächen
- 10: Vertiefung für elektrische Kontaktflächen
- 11: Vertiefung
- 12: Auflagesteg
- 13: innere Fläche
- 14: Durchgangskanal
- 15: Durchgangskanal
- 16: Führungsbegrenzung
- 17: Nut
- 18: Durchflusszelle
- 19: Oberes Gehäuseteil
- 20: Unteres Gehäuseteil
- 21: Scharniergelenk
- 22: Schließhaken
- 23: Fluidkanalsystem
- 24: Ausnehmung
- 25: Öffnung des Fluidkanalsystem
- 26: Öffnung des Fluidkanalsystem
- 27: Dichtringe
- 28: Bonddrähte
- 29: Sensorelement
- 30: Durchflußzellenvolumen
- 31: Federkontakt
- 32: Trägerplatte
- 33: Kühlkörper
- 34: Grundplatte
- 35: Heiz-/Kühleinrichtung
- 36: Druckplatte
- 37: Oszillator
- 38: Oszillatorgehäuse
- 39: Deckel
- 40, 41: Halteelemente
- OS: offene Stellen
- E: Elektrodenbereich
- G: Gegenelektrodenbereich
- ZW: Zwischenraum
- A: Absatz

## Patentansprüche

1. Piezoelektrischer Resonator, der flächig ausgebildet ist, mit einem auf der Oberfläche des piezoelektrischen Resonators aufgebrachten Elektroden- und mindestens einem Gegenelektrodenbereich,
dadurch **gekennzeichnet**, daß eine erste Seite des piezoelektrischen Resonators ausschließlich einen Elektrodenbereich vorsieht, der elektrisch leitend mit einem Elektrodenbereich auf der zweiten Seite des piezoelektrischen Resonators verbunden ist, auf der gegenüber dem Elektrodenbereich elektrisch isoliert mindestens ein Gegenelektrodenbereich vorgesehen ist.

2. Piezoelektrischer Resonator nach Anspruch 1,
dadurch **gekennzeichnet**, daß der piezoelektrische Resonator als Schwingquarzplättchen ausgebildet ist.

3. Piezoelektrischer Resonator 2, dadurch **gekennzeichnet**, daß das Schwingquarzplättchen als
Dickenscherschwinger aus α-Quarz im AT-Schnitt ausgebildet ist.

4. Piezoelektrischer Resonator einem der Ansprüche 1 bis 3,
dadurch **gekennzeichnet**, daß der Elektrodenbereich auf der ersten Seite des piezoelektrischen Resonators wenigstens stellenweise über den Rand des piezoelektrischen Resonators auf die zweite Seite des Resonators geführt ist.

5. Piezoelektrischer Resonator nach einem der Ansprüche 1 bis 4,
dadurch **gekennzeichnet**, daß ein Gegenelektrodenbereich mittig auf dem Resonator aufgebracht ist und vom Elektrodenbereich beabstandet ist.

6. Piezoelektrischer Resonator nach einem der Ansprüche 1 bis 5,
dadurch **gekennzeichnet**, daß 2 oder mehr Gegenelektrodenbereiche auf dem Resonator aufgebracht sind.

7. Piezoelektrischer Resonator nach einem der Ansprüche 1 bis 6,
dadurch **gekennzeichnet**, daß die Elektroden- und Gegenelektrodenbereiche als elektrisch leitende Schicht auf der Resonatoroberfläche aufgebracht sind.

8. Piezoelektrischer Resonator nach einem der Ansprüche 1 bis 7,
dadurch **gekennzeichnet**, daß die Elektroden- und Gegenelektrodenbereiche aus einer Goldschicht bestehen.

9. Piezoelektrischer Resonator nach Anspruch 8,
dadurch **gekennzeichnet**, daß zwischen der Resonatoroberfläche und der Goldschicht eine Haftschicht vorgesehen ist.

10. Piezoelektrischer Resonator nach Anspruch 9,
dadurch **gekennzeichnet**, daß die Haftschicht NiCr, Cr, Ni, Ti oder W aufweist.

11. Piezoelektrischer Resonator nach einem der Ansprüche 1 bis 10,
dadurch **gekennzeichnet**, daß der Elektroden- und Gegenelektrodenbereich, die auf der zweiten Seite des Resonators aufgebracht sind, eine Struktur aufweisen, die mit Anschluß- bzw. Bonddrähten verbindbar sind.

12. Piezoelektrischer Resonator nach einem der Ansprüchen 1 bis 11,
dadurch **gekennzeichnet**, daß der Gegenelektrodenbereich einen stegartigen Absatz aufweist, der zum Anbringen eines Anschluß- bzw. Bondrahtes vorgesehen ist.

13. Piezoelektrischer Resonator nach einem der Ansprüche 1 bis 12,
dadurch **gekennzeichnet**, daß die erste Seite des Resonators mit einer chemischen oder biochemischen Schicht überzogen ist.

14. Sensorelement zum Erfassen der Konzentration eines in einem Fluid enthaltenen Stoffes oder zur Bestimmung physikalischer Eigenschaften eines Fluids, mit dem piezoelektrischen Resonator nach einem der Ansprüche 1 bis 13, dessen Elektroden- und Gegenelektrodenbereich mit einer Signalquelle und einer Meßanordnung derart verbindbar sind, daß der Elektroden- und Gegenelektrodenbereich ausschließlich von der zweiten Seite des piezoelektrischen Resonators elektrisch kontaktierbar sind.

15. Sensorelement nach Anspruch 14,
dadurch **gekennzeichnet**, daß das Fluid mit der ersten Seite des piezoelektrischen Resonators in Kontakt bringbar ist und der piezoelektrische Resonator derart ausgebildet ist, daß sein Resonanzverhalten durch die physikalischen Eigenschaften des Fluids veränderbar ist und mittels der Meßanordnung erfassbar ist.

16. Sensorelement nach Anspruch 14 oder 15,
dadurch **gekennzeichnet**, daß die erste Seite des piezoelektrischen Resonators mit einer chemischen oder biochemischen Schicht überzogen ist und mit dem Fluid in Kontakt bringbar ist, und daß infolge einer selektiven Reaktion mit dem im Fluid enthaltenen Stoffes eine Massenänderung der chemischen oder biochemischen Schicht verbunden ist, durch die das Resonanzverhalten des piezoelektrischen Resonators beeinflußbar ist, das mittels der Meßanordnung erfassbar ist.

17. Verfahren zur Herstellung einer Beschichtung auf einem Substratplättchen, insbesondere zur Beschichtung des piezoelektrischen Resonators nach einem der Ansprüche 1 bis 13,
**gekennzeichnet** durch die Kombination folgender Verfahrensschritte:
- Bestücken eines Trägers mit wenigstens einem Substratplättchen, der das Plättchen an wenigstens einer Fixierstelle derart fixiert, daß das Plättchen ansonsten für den Beschichtungsvorgang frei zugänglich ist,
- Aufbringen einer Abschattungsmaske auf den mit dem Substratplättchen bestückten Träger, wobei die Abschattungsmaske derart strukturiert ist, daß ein Bereich auf der Plättchenoberfläche, der nicht beschichtet werden soll, von einer Maskenstruktur abgedeckt wird,
- Aufbringen eines Fixierdeckels auf die Abschattungsmaske, der identisch zum Träger strukturiert ist,
- beidseitiges Beschichten des Substratplättchens.

18. Verfahren nach Anspruch 17,
dadurch **gekennzeichnet**, daß der Beschichtungsvorgang mittels CVD oder Sputter-Verfahren durchgeführt wird und das Substratplättchen beidseitig beschichtet wird.

19. Verfahren nach Anspruch 17 oder 18,
dadurch **gekennzeichnet**, daß das Substratplättchen zunächst mit NiCr, Cr, Ni, Ti und/oder W zur Herstellung einer Haftschicht und anschließend mit einem elektrisch leitenden Material beschichtet wird.

20. Verfahren nach Anspruch 19,
dadurch **gekennzeichnet**, daß die Haftschicht eine Schichtdicke von etwa 10 bis 50 nm und die Schichtdicke der Schicht aus elektrisch leitendem Material von 50 bis 500 nm aufweisen.

21. Verfahren nach einem der Ansprüche 17 bis 20,
dadurch **gekennzeichnet**, daß das Substratplättchen mit SiC, Si₃N4, SiO₂ zur Herstellung einer Passivierungsschicht beschichtet wird.

22. Verfahren nach einem der Ansprüche 17 bis 21,
dadurch **gekennzeichnet**, daß der Träger, die Abschattungsmaske sowie die Fixiervorrichtung eine Vielzahl von Ausnehmungen zum Einbringen von zu beschichtenden Substratplättchen aufweisen.

23. Verfahren nach einem der Ansprüche 17 bis 22,
dadurch **gekennzeichnet**, daß das in den Masken eingebrachte Substratplättchen vor dem Beschichtungsvorgang zur Reinigung beidseitig einem Ätzvorgang unterzogen wird.

24. Verfahren nach einem der Ansprüche 17 bis 23,
dadurch **gekennzeichnet**, daß der vollständige Beschichtungsvorgang unterbrechungsfrei und ohne Öffnen der Masken durchgeführt wird.

25. Vorrichtung in Art einer Durchflußzelle, in die das Sensorelement nach einem der Ansprüche 14 bis 16 integrierbar ist, mit einer, zwei elektrische Kontakbereiche aufweisenden Oberfläche, die über Anschluß- bzw. Bonddrähte mit den Kontaktbereichen für die Elektrode und Gegenelektrode des Sensorelementes verbindbar sind.

26. Vorrichtung nach Anspruch 25,
dadurch **gekennzeichnet**, daß die Durchflußzelle als eine Vertiefung in einem Körper ausgebildet ist, auf die das Sensorelement aufbringbar ist und mit der Durchflußzelle einen Hohlraum einschließt, der mit wenigstens zwei die Durchflußzelle durchstoßende Durchgangskanäle verbunden ist, durch die das zu untersuchende Fluid zu- bzw. ableitbar ist.

27. Vorrichtung nach Anspruch 26,
dadurch **gekennzeichnet**, daß die Vertiefung kreisförmig ausgebildet ist.

28. Vorrichtung nach einem der Ansprüche 25 bis 27,
dadurch **gekennzeichnet**, daß in die Oberfläche ein umlaufender Auflagesteg eingearbeitet ist, auf den das Sensorelement aufbringbar ist.

29. Vorrichtung nach einem der Ansprüche 25 bis 28,
dadurch **gekennzeichnet**, daß wenigstens zwei seitliche Führungsbegrenzungen vorgesehen sind, die das Sensorelement auf der Oberfläche zentrieren.

30. Vorrichtung nach Anspruch einem der Ansprüche 25 bis 29,
dadurch **gekennzeichnet**, daß die Durchflußzelle als scheibenartiges Spritzgußteil herstellbar ist.

31. Vorrichtung nach einem der Ansprüche 25 bis 30,
dadurch **gekennzeichnet**, daß die elektrischen Kontaktbereiche auf der Oberfläche in zwei Aussparungen, die in die Durchflußzelle eingearbeitet sind, eingebracht sind.

32. Vorrichtung nach einem der Ansprüche 25 bis 31,
dadurch **gekennzeichnet**, daß die elektrischen Kontaktbereiche aus goldbeschichteten Siliziumplättchen bestehen.

33. Vorrichtung nach einem der Ansprüche 25 bis 32,
dadurch **gekennzeichnet**, daß das Sensorelement mit der Durchflußzelle fest verklebt ist.

34. Vorrichtung nach einem der Ansprüche 28 bis 33,
dadurch **gekennzeichnet**, daß um den umlaufenden Auflagesteg eine Grabenstruktur in der Durchflußzelle vorgesehen ist, der zur Aufnahme von überschüssigem Klebstoff dient.

35. Vorrichtung nach einem der Ansprüche 25 bis 34,
dadurch **gekennzeichnet**, daß die Durchflußzelle aus Kunststoff, vorzugsweise aus Polyarlyetherketon, gefertigt ist.

36. Anordnung zum Erfassen der Konzentration eines in einem Fluid enthaltenen Stoffes und/oder der Bestimmung physikalischer Eigenschaften des Fluids unter Verwendung der Durchflußzelle nach einem der Ansprüche 25 bis 35,
die fluiddicht an ein Fluidkanalsystem ankoppelbar ist und die einseitig mit Anschlußelektroden für die Signalquelle und Meßanordnung an den elektrischen Kontaktbereichen an der Oberfläche der Durchflußzelle verbindbar sind.

37. Anordnung nach Anspruch 36,
dadurch **gekennzeichnet**, daß ein Gehäuse vorgesehen ist, das zwei gegeneinander festlegbare Gehauseteile aufweist, zwischen denen die Durchflußzelle einbringbar ist und fluiddicht an das, in einem Gehäuseteil vorgesehene Fluidkanalsystem ankoppelbar ist,
wobei die Durchflußzelle in das mit dem Fluidkanalsystem vorgesehene Gehäuseteil derart entnehmbar einbringbar ist, daß eine fluiddichte Ankopplung des Fluidkanalsystems an die Durchgangskanäle der Durchflußzelle mittels Dichtungen möglich ist,
und das andere Gehäuseteil die Anschlußelektroden aufweist, die auf die elektrischen Kontaktbereiche der Durchflußzelle aufsetzbar sind, und
durch Festlegen beider Gehäuseteile gegeneinander die Durchflußzelle relativ zum Fluidkanalsystem und zu den Anschlußelektroden fixierbar ist.

38. Anordnung nach Anspruch 36 oder 37,
dadurch **gekennzeichnet**, daß die Anschlußelektroden als Federkontakte ausgebildet sind.

39. Anordnung nach einem der Ansprüche 36 bis 38,
dadurch **gekennzeichnet**, daß das, das Fluidkanalsystem aufweisende Gehäuseteil eine an die Kontur der Durchflußzelle angepaßte Ausnehmung vorsieht, in die die Durchflußzelle einlegbar ist.

40. Anordnung nach Anspruch 39,
dadurch **gekennzeichnet**, daß das Fluidkanalsystem aufweisende Gehäuseteil thermisch an einen Temperaturfühler und/oder an eine Heiz-/Kühleinrichtung angekoppelt ist.

41. Anordnung nach Anspruch 40,
dadurch **gekennzeichnet**, daß die Heiz-/Kühleinrichtung ein Peltierelement ist.

42. Anordnung nach Anspruch 40 oder 41,
dadurch **gekennzeichnet**, daß das Flüssigkeitskanalsystem wenigstens abschnittsweise thermisch an die Heiz-/Kühleinrichtung gekoppelt ist.

43. Anordnung nach einem der Ansprüche 39 bis 42,
dadurch **gekennzeichnet**, daß beide Gehäuseteile schwenkbar um eine Achse miteinander verbunden sind.

44. Anordnung nach einem der Ansprüche 39 bis 43,
dadurch **gekennzeichnet**, daß das andere Gehäuseteil zum flüssigkeitsdichten Andrücken der Durchflußzelle an das Fluidkanalsystem eine Druckplatte, die Signalquelle sowie eine Schließvorrichtung aufweist.

45. Anordnung nach Anspruch 44,
dadurch **gekennzeichnet**, daß die Schließvorrichtung als Schließhaken mit Scharnier ausgebildet ist, der beide Gehäuseteile lösbar fest gegeneinander lagert.

46. Verwendung der Anordnung nach einem der Ansprüche 36 bis 45 zur Konzentrationsbestimmung biochemischer Stoffe, insbesondere zur Verwendung als Immunosensor.

47. Verwendung der Anordnung nach einem der Ansprüche 36 bis 45 zur Messung einer Reaktionskinetik zwischen mindestens zwei Substanzen, wobei eine Substanz an der Oberfläche des Sensorelementes immobilisiert ist.

48. Verwendung der Anordnung nach einem der Ansprüche 36 bis 47 zur Messung der Dichte, Viskosität und/oder Elastizität eines zu untersuchenden Fluids.

49. Verwendung nach Anspruch 48,
dadurch **gekennzeichnet**, daß durch bloße Kontaktierung des Sensorelementes mit dem zu untersuchenden Fluid durch dessen Einflußnahme auf das geänderte Resonanzverhalten des piezoelektrischen Resonators die physikalischen Eigenschaften des Fluids bestimmbar sind.

50. Verwendung nach Anspruch 48 oder 49 als Waschmittelsensor.

51. Verwendung nach Anspruch 48 oder 49 als Prozeßrheometer.
